# EUROPEAN PATENT SPECIFICATION

(11) **EP 3 729 527 B1**
(45) Date of publication and mention of the grant of the patent: **23.02.2022**
(21) Application number: 18833875.0
(22) Date of filing: 20.12.2018
(51) Int. Cl.: H01L 35/22

(54) **ELECTRIC POWER GENERATOR, POWER GENERATOR MODULE AND ELECTRIC CIRCUIT**
STROMGENERATOR, STROMGENERATOR-MODUL UND ELEKTRISCHE SCHALTUNG
GÉNÉRATEUR DE PUISSANCE ÉLECTRIQUE, MODULE GÉNÉRATEUR DE PUISSANCE ET CIRCUIT ÉLECTRIQUE

(30) Priority: 20.12.2017 WO PCT/EP2017/083786
(43) Date of publication of application: 28.10.2020
(73) Proprietor: Termo-IND S.A., 6830 Chiasso (CH)
(72) Inventor: MAGAGNIN, Luca, 20017 RHO (IT); IEFFA, Simona, 22070 VALMOREA (IT); ACCOGLI, Alessandra, 73030 DISO (IT); PANZERI, Gabriele, 20872 CORNATE D'ADDA (IT); LIBERALE, Francesco, 27100 PAVIA (IT); TIRELLA, Vincenzo, 6877 COLDRERIO (CH); GIBERTINI, Eugenio, 20090 CUSAGO (IT); SUCCA, Luca, 00125 ROMA (IT); BRUNETTI, Simone, 00126 ROMA (IT)
(74) Representative: Cattaneo, Elisabetta
(86) International application number: PCT/EP2018/086344
(87) International publication number: WO 2019/122215

(56) References cited:
- EP-A1- 0 924 721
- EP-A2- 2 902 518
- US-A1- 2008 268 382
- US-A1- 2012 145 214

## Description

### FIELD OF THE INVENTION

The present invention relates to an electric power generator (EPG) comprising an active material, a power generator module (PGM) and an electric circuit (EC).

### STATE OF THE ART

It is widely known the use of thermoelectric power generators and thermionic power generators for the conversion of thermal energy directly into electrical energy.

The thermoelectric power generators are devices based on a thermoelectric effect, namely the Seebeck effect, involving interactions between the flow of heat and of electricity between solid bodies. Examples of such devices are disclosed in the patent EP 2521192 and in the patent application EP 2277209. In broad terms, thermoelectric power generators consist of three main components: thermoelectric material, thermoelectric modules and thermoelectric system that interface with a heat source.

Thermoelectric materials generate power directly from heat by converting temperature differences into electric voltage. In particular, these materials typically have both high electrical conductivity and low thermal conductivity. The low thermal conductivity ensures that when one side is made hot, the other side stays cold. This helps to generate a large voltage while in a temperature gradient.

A thermoelectric module is a circuit containing thermoelectric materials which generate electricity from heat directly. A module consists of two dissimilar thermoelectric materials joining at their ends, namely a negatively charged semiconductor and a positively charged semiconductor. A direct electric current will flow in the circuit when there is a temperature gradient between the two materials. Such gradient is provided by the thermoelectric system which typically comprise heat exchangers used on both sides on the module to supply respectively heating and cooling.

A thermionic power generators, also called thermionic power converters, convert heat directly into electricity. A thermionic power generator typically comprises two electrodes arranged in a containment. One of these is raised to a sufficiently high temperature to become a thermionic electron emitter or "hot plate". The other electrode is called collector because it receives the emitted electrons. The collector is operated at significantly lower temperature. The space between the electrodes can be vacuum or alternatively filled with a vapour gas at low pressure. The thermal energy may be supplied by chemical, solar or nuclear sources.

Thermoelectric power generators as well as thermionic power generators have many drawbacks, among which the low conversion efficiency and the need of providing a temperature gradient. In addition, such generators, requires relatively constant thermal source.

Therefore, it is the primary object of the present invention to provide an electric power generator capable to convert part of the thermal energy in electric energy and allowing to overcome the drawbacks of the devices of the prior art.

In WO2018/029139 A1 it is already described an active material capable to be applied on one electrode and to generate current when comprised between at least two electrodes, surprisingly without initial charging and dependently on the temperature. Specifically, the material described in WO2018/029139 A1 comprises at least one oxygen-containing compound selected from the group consisting of MgO, ZnO, ZrOCl₂, ZrO₂, SiO₂, Bi₂O₃, Al₂O₃ and TiO₂, at least one thickener additive selected from the group consisting of agar agar, xanthan gum, methyl cellulose, and arabic gum, and at least one plasticizer additive, wherein the particle size of the oxygen-containing compound has a specific average diameter. EP 0 924 721 A1 describes a dielectric ceramic comprising MgO, SiO₂, Al₂O₃ or CaO.

The inventors found out that the performances of the active material were worse in the presence of temperatures above 80°C, and that the temperature above 90°C induced the degradation of the active material with lowering of the device performances and the decrease of stability of the final device.

A further object of the invention is therefore to provide an electric generator capable to provide electric energy in a wide range of temperatures.

A still further object is hence to provide an electric device capable to generate electric energy having also high stability to temperature.

### SUMMARY OF THE INVENTION

The inventors surprisingly found out that they can provide a new active material capable to be applied on one electrode and to generate current when comprised between at least two electrodes without initial charging and dependently on the temperature without the disadvantages of the prior art devices.

Therefore the invention according to claim 1 relates to an electric power generator (EPG) comprising at least two electrodes, placed at a suitable distance from each other and preferably made of different material, comprising between said electrodes an active material comprising at least one oxygen-containing compound selected from the group consisting of MgO, ZnO, ZrOCl₂, ZrO₂, SiO₂, Bi₂O₃, Fe₃O₄, Al₂O₃,TiO₂, BeO, CaO, Ga₂O₃, In₂O₃, GeO₂, SnO₂ and PbO₂, wherein the particle size of the oxygen-containing compound has an average diameter in the range from 10 nm to 40 µm and wherein a thickener additive selected from the group consisting of agar agar, xanthan gum, methyl cellulose, and arabic gum is absent and wherein the at least one oxygen-containing compound or a mixture thereof is in an amount in the range from 50% to 100% (w/w) with respect to the amount of the active material.

Specifically, the inventors found out that they have to eliminate the thickener additive in order to overcome the disadvantages of the devices of the prior art. Therefore, the inventors propose a new substantially dry state device, as alternative and improvement respect to the devices of the prior art.

In a preferred embodiment a cellulose compound as a thickener agent is further absent in the active material of the invention. In a further preferred and advantageous embodiment, the at least one oxygen-containing compound selected from the group consisting of MgO, ZnO, ZrOCl₂, ZrO₂, SiO₂, Bi₂O₃, Fe₃O₄, Al₂O₃,TiO₂, BeO, CaO, Ga₂O₃, In₂O₃, GeO₂, SnO₂ and PbO₂ or a mixture thereof is in an amount in the range 50-80% (w/w) with respect to the amount of the active material.

The active material of the EPG of the invention can hence be anhydrous or can contain a certain amount of water, as coordinated water molecules to the oxygen-containing compound, deriving from the process for preparing the active material: the inventors deem that such coordinated water in the final active material can ameliorate the performances of the final devices obtained by incorporating the active material. The oxygen-containing compound can contain coordinated water in the range from 0.5% by weight to 7.5% by weight with respect to oxygen-containing compound preferably from 0.5% to 3.5%, more preferably from 0.5% to 1.5%.

Without being bound to any theory the inventors deem that thickener additives used in the prior art are organic materials used to increase the viscosity of a liquid dispersion. However, the inventors found out that these materials have intrinsic low thermal stability induced by the reversibility of gelification process if a temperature higher than their melting temperature was applied. For example, agar agar gels and melts respectively at 40°C and 80°C and methylcellulose at 62°C and 68°C respectively.

Consequently, the exposition of these materials to high temperatures induced active material degradation and hence worsen the stability of the final device.

According to the present invention the EPG is capable to provide electric energy in a wide range of temperatures.

The invention also provides an electric device capable to generate electric energy having also high stability to temperature.

In a preferred embodiment of the invention the active material comprises MgO, ZnO and ZrO₂ as powder as oxygen-containing compounds.

Therefore, the EPG according to the invention comprises oxygen-containing compounds between the at least two electrodes. The electrodes are made of metals, alloys and/or carbon-based materials like graphite. Electrodes thickness ranges preferably from 0.1 to 3000 µm, more preferably from 50 to 1000 µm, still more preferably from 300 to 600 µm. In another embodiment of the invention, these electrodes are made of powders with particle average diameter in the range from 10 nm to 40 µm, preferably in the range of 10 nm to 20 µm, more preferably 10-100 nm. In a preferred embodiment of the EPG according to the invention, the at least two electrodes are made of Al and graphite, in form of foil and powder respectively. In case of flexible EPG both self-standing flexible materials (among the previous listed materials) and metallized polymers can be considered as electrodes.

The inventors do not exclude the possibility to recharge the EPG applying a voltage to the EPG at a constant temperature or during a thermal path.

The present invention also relates to a power generator module (PGM) according to claim 19 comprising a plurality of EPG which can be connected in series or parallel without compromising the EPG characteristics (voltage and current).

The present invention also relates to an electric circuit (EC) according to claims 20 and 21 comprising the PGM.

### DESCRIPTION OF FIGURES

Further features and advantages of the invention will be more apparent in light of the detailed description of the active material and of the preferred embodiments of the electric power generator with the aid of enclosed drawings in which:
- Figure 1 shows the structure of an electric power generator (EPG) according to the present invention;
- Figures 1A and 1B show respectively a first embodiment and a second embodiment of a power generator module (PGM) comprising a plurality of EPG according to the present invention;
- Figures 2A and 2B show an electrical circuit, in two different operative configurations, used for the electrical characterization of an EPG according to the invention;
- Figure 3 shows an electrical circuit usable for the electrical characterization of a PGM comprising a plurality of EPG according to the invention;
- Figure 4 shows an electrical circuit used for the electrical characterization of example 10;
- Figure 5 shows the results of electrical characterization of example 10;
- Figure 6 shows an electrical circuit used for the electrical characterization of example 11;
- Figure 7 shows the results of electrical characterization of example 11;
- Figures 8 and 9 show the results of electrical characterization of example 12;
- Figure 10 shows the results of electrical characterization of example 13;
- Figure 11 shows the electrical circuit used for the electrical characterization of example 14; and
- Figure 12 shows the results of electrical characterization of example 14.

### DETAILED DESCRIPTION OF THE INVENTION

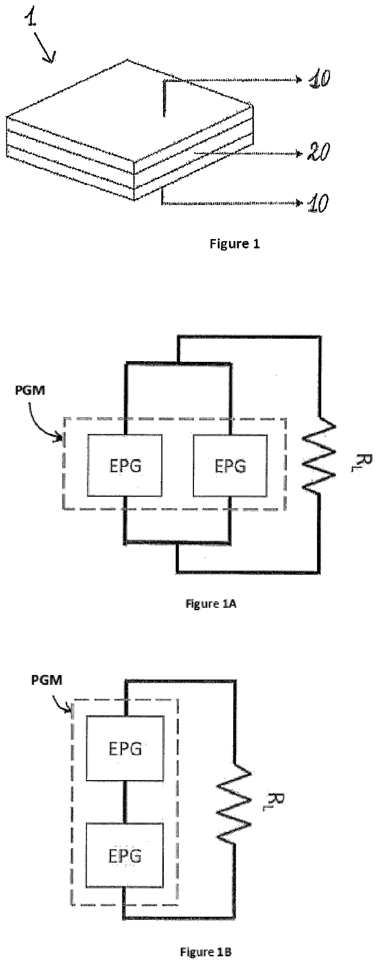

The invention hence relates to an electric power generator (EPG) comprising at least two electrodes 10, placed at a suitable distance from each other and preferably made of different material, comprising an active material 20 between said electrodes 10. The structure of an EPG is shown in Figure 1. According to the invention, said active material comprises at least one oxygen-containing compound selected from the group consisting of MgO, ZnO, ZrOCl₂, ZrO₂, SiO₂, Bi₂O₃, Fe₃O₄, Al₂O₃,TiO₂, BeO, CaO, Ga₂O₃, In₂O₃, GeO₂, SnO₂ and PbO₂, wherein the particle size of the oxygen-containing compound has an average diameter in the range from 10 nm to 40 µm and wherein a thickener additive selected from the group consisting of agar agar, xanthan gum, methyl celluloseand arabic gum is absent.

In a further preferred and advantageous embodiment, the at least one oxygen-containing compound selected from the group consisting of MgO, ZnO, ZrOCl₂, ZrO₂, SiO₂, Bi₂O₃, Fe₃O₄, Al₂O₃,TiO₂, BeO, CaO, Ga₂O₃, In₂O₃, GeO₂, SnO₂ and PbO₂ or a mixture thereof is in an amount in the range from 50% to 100% (w/w) with respect to the amount of the active material, more preferably 50-80% (w/w).

The active material of the EPG of the invention could comprises also at least one plasticizer additive. The at least one plasticizer additive is preferably selected from the group consisting of siloxanes, Carnauba Wax, Naphtalene, PVDF, Parylene, PTFE, FEP, PDMS, aqueous based polymers and bio-polymers.

The active material can comprise further compounds as additive, preferably Antrachene, PZT materials, and Si₃N₄.

It is reasonably thought that the combined use of these materials with the oxygen-containing compounds of the invention could enhance the performances of the device or, at least, improve the results obtained under particular regimes.

The active material of the EPG of the invention can be anhydrous or can contain a certain amount of the water, as coordinated water molecules, deriving from the process for preparing it: the inventors deem that such coordinated water in the final active material can ameliorate the performances of the final devices obtained by incorporating the active material. The oxygen-containing compound can contain coordinated water in the range from 0.5% by weight to 7.5% by weight with respect to oxygen-containing compound preferably from 0.5% to 3.5%, more preferably from 0.5% to 1.5%.

Particles of oxygen-based compounds of the active material have an average diameter in the range from 5 nm to 40 µm, preferably 15 nm-10 µm, more preferably 20 nm-5 µm. In another advantageous and preferred aspect of the invention, the particles of oxygen-based compounds have an average diameter in the range from 10-200 nm, more preferably in the range of 15-100 nm, still more preferably 20-40 nm.

The active material of the EPG of the invention comprises preferably magnesium oxide as oxygen-containing compound, more preferably in the weight percentage in the range from 50% to 1 100% (w/w), preferably from 50% to 80% (w/w) with respect to the amount of the active material.

The active material comprises preferably zirconium oxide as oxygen-containing compound, more preferably in the weight percentage in the range from 50% to 100% (w/w), preferably from 50% to 80% (w/w) with respect to the amount of the active material.

The active material preferably comprises MgO with ZrO₂ as oxygen-containing compounds, more preferably in the weight percentage in the range from 50% to 100% (w/w), still more preferably in the range of 50% to 80% (w/w) with respect to the amount of the active material.

The active material preferably comprises MgO together with both ZnO and ZrO₂ as oxygen-containing compounds, more preferably each one in the weight percentage in the range from 50% and 90% (w/w), still more preferably in the range of 50% and 80% (w/w) with respect to the amount of the active material.

The EPG of the invention comprises the active material between the at least two electrodes.

The oxygen-based compounds of the active material can be placed as powder on at least one electrode and pressed against the other metal electrode using a machine press. Alternative techniques already known in the art can be used, for example sol-gel, inkjet printing and sputtering.

The electrodes are made of metals, alloys and/or carbon-based materials like graphite. Electrodes thickness ranges preferably from 0.1 to 3000 µm, more preferably from 50 to 1000 µm, still more preferably from 300 to 600 µm. In a preferred embodiment of the EPG according to the invention, the at least two electrodes are made of Cu and Al, preferably in form of plates or foils substantially parallel. In case of flexible EPG both self-standing flexible materials (among the previous listed materials) and metallized polymers can be considered as electrodes.

In a preferred embodiment of the EPG 1 schematically shown in Fig. 1, the at least two electrodes 10 have a plate-shape. The two plates are arranged substantially parallel each other so as to define a gap filled with the active material 20 of the invention according to a *"sandwich structure".* The distance of the electrodes 10 depends directly on the desired thickness of the active material to be applied.

The shape of the electrodes is not binding. In an alternative embodiment, for example, the EPG could comprise two coaxial cylindrical electrodes that define an annular space filled with the active material according to the invention. According to the invention, the EPG could comprise more than two electrodes wherein two adjacent electrodes define a gap filled with the active material.

According to a preferred embodiment, the at least two electrodes are made of different material, preferably of Cu and Al. The two at least electrodes are preferably subjected to cleaning and etching prior to be used in the electric power generator of the invention.

The active material of the EPG of the invention is preferably applied on the electrode, by depositing the active material in a thickness from 100 nm to 5 mm. On the other hand, the optimal thickness varies depending on applications.

In a further aspect, the invention relates to a power generator module (PGM) comprising a plurality of EPG which can be connected in series or parallel. On this regards, Figure 1A shows a circuit comprising a PGM wherein the two EPG are connected in parallel, while Figure 1B shows a circuit comprising a PGM having two EPG connected in series. Both the circuits of Figures 1A and 1B comprise a load resistance R_{L}. The voltage relative to the PGM can be monitored, for example, by connecting a potentiostat/ galvanostat parallel to the load resistance R_{L}.

The active material of the EPG according to the invention can be prepared preferably by pressing the powders of the one or more oxygen-containing compounds having the average diameter according to the invention. The pressing step can be preferably carried out directly on one of the two electrodes of the EPG of the invention.

Alternatively, the active material can be deposited as a composition on one of the two electrodes and after subjected to a baking step in order to obtain a substantially dry product.

Without being bound to any theory the inventors deem that fluxing different selected gaseous species during the preparation procedure of the active material could enhance the final performances of the as obtained EPG, in terms of open circuit voltage (OCV), according to the series N₂ > Air (wet) > Air (dry) > O₂ (dry) > CO₂ (dry).

In another aspect of the invention, inventors deem that the proposed active material contained in the EPG of the invention could be reasonably integrated in the mix of active materials adopted for the manufacturing of commonly used capacitors.

Therefore in another aspect the invention concerns the use of an active material comprising at least one oxygen-containing compound selected from the group consisting of MgO, ZnO, ZrOCl₂, ZrO₂, SiO₂, Bi₂O₃, Fe₃O₄, Al₂O₃,TiO₂, BeO, CaO, Ga₂O₃, In₂O₃, GeO₂, SnO₂ and PbO₂, wherein the particle size of the oxygen-containing compound has an average diameter in the range from 10 nm to 40 µm and wherein a thickener additive selected from the group consisting of agar agar, xanthan gum, methyl cellulose, and arabic gum is absent for manufacturing capacitors.

In a further aspect the invention relates to a capacitor comprising at least a first electrode, a second electrode and an active material comprising at least one oxygen-containing compound selected from the group consisting of MgO, ZnO, ZrOCl₂, ZrO₂, SiO₂, Bi₂O₃, Fe₃O₄, Al₂O₃,TiO₂, BeO, CaO, Ga₂O₃, In₂O₃, GeO₂, SnO₂ and PbO₂,, wherein the particle size of the oxygen-containing compound has an average diameter in the range from 10 nm to 40 µm and wherein a thickener additive selected from the group consisting of agar agar, xanthan gum, methyl cellulose, and arabic gum is absent.

In a preferred embodiment a cellulose compound as a thickener agent is further absent in the active material of the invention.

In a further preferred and advantageous embodiment, the at least one oxygen-containing compound selected from the group consisting of MgO, ZnO, ZrOCl₂, ZrO₂, SiO₂, Bi₂O₃, Fe₃O₄, Al₂O₃,TiO₂, BeO, CaO, Ga₂O₃, In₂O₃, GeO₂, SnO₂ and PbO₂ or a mixture thereof is in an amount in the range from 50% to 100% (w/w) with respect to the amount of the active material, more preferably 50-80% (w/w).

The preferred features relating to EPG according to the invention can be the same for the capacitor according to the invention in view of the same technical peculiarities.

As it will be evident from the following experimental part the EPG of the invention is capable to generate current as soon as it has been assembled, thus being a different device from a conventional capacitor. Furthermore and surprisingly, the performances of the EPG of the invention have a strongly dependence on temperature, i.e. potential difference increases with the temperature. In particular, with respect to the traditional power generators of the prior art, the EPG according to the invention does not require a temperature gradient. Indeed, the electric power generator of the invention is capable to convert part of the thermal energy in electric energy even an isotherm condition. Specifically and advantageously, the current measured by the electric power generator of the invention is increased by a factor of 1.5-4, increasing the temperature from 20 to 80°C.

According to the present invention the EPG is advantageously capable to provide electric energy in a wide range of temperatures. Advantageously, the electric energy provided by the EPG has high stability to temperature.

The EPG of the invention was characterized by the electric point of view. First, the open circuit voltage (OCV) was measured by means of a multimeter, the EPG device showed a voltage of 1 V in the configuration comprising aluminum and graphite as electrodes and a mixture of oxides with MgO as major component. Other EPG devices according to the invention were prepared and depending on the components, electrodes and powders materials, the results varied from 50 mV to 1200 mV.

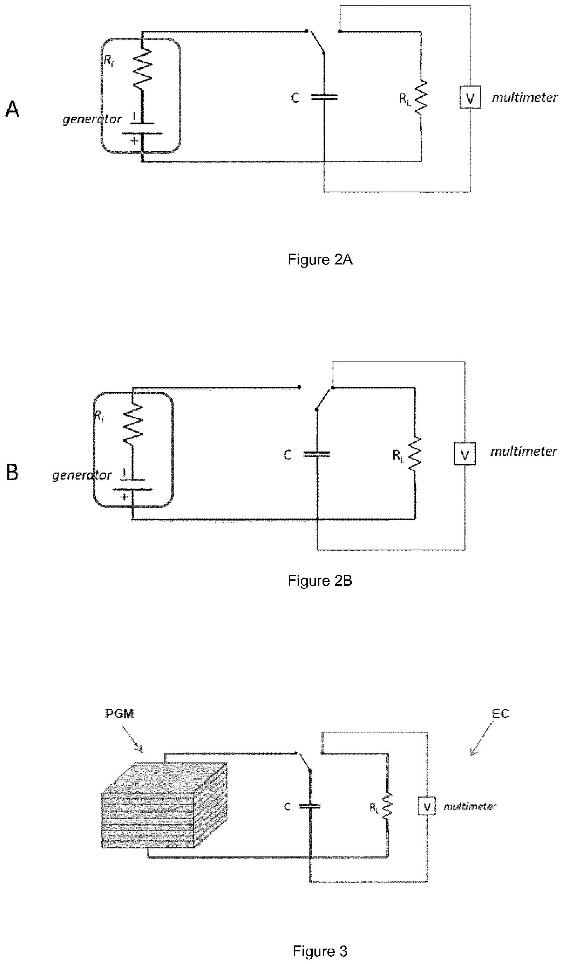

With reference to Figures 2A and 2B. A dedicated electrical circuit EC was selected in order to characterize the EPG from the electrical point of view. In particular, EPG based on mixed oxides powder were tested. As shown in the circuit in Figure 2A the EPG was connected in series with a capacitor C with initial voltage Vi=0 V. More precisely, the electrical circuit EC comprises a switch SW that connected the EPG to the capacitor C in a first switching state. During a charge phase (Figure 2A), the EPG charged the capacitor up to an equilibrium voltage. Once the capacitor was charged, the switch SWwas activated (in a second switching state), thus connecting the capacitor to an arbitrary load resistor R_{L} for discharging the capacitor (discharge phase or rest phase); the EPG was now electrically isolated (Figure 2B). With the term resistor is generally meant an electric resistor, a diode, a combination thereof, or any electrical component able to discharge the capacitor C when the switch SW is in said second switching state.

The energy stored in the capacitor was calculated from characteristic capacity and the charged voltage (Vc), measured by means of a multimeter; preferably an electrochemical capacitor was employed in this setup. In one of the test carried out, a temporized switch was used to alternate charge of the capacitor and the rest phase where the EPG was electrically isolated, in this phase voltage cell recover occurred. During this phase (Figure 2B) the capacitor connected in series with an arbitrary resistor (RL) with the only purpose to discharge it completely prior the beginning of the next charge cycle, the discharge curve was monitored by means of a multimeter.

Figure 3 shows a PGM in the same testing electrical circuit as in Figure 2.

The invention will now be illustrated by some not limitative examples of the active material and EPG of the invention.

### Examples:

### Example 1:

### Preparation of an EPG of the invention

In a typical procedure, aluminum foil of thickness of about 100 µm is placed at the bottom of a circle-shaped mold of 2 cm diameter. 0.1 g of MgO powder with average diameter in the range from 10 nm to 40 µm, preferably in the range of 1-10 µm, more preferably 2-5 µm as sold by Sigma-Aldrich is sprinkled on Al and gently pressed with a piston at 0.01 MPa to compact the active powder. Graphite powder (100 µm mesh, 0.05 g) or copper powder (20 µm mesh, 0.03 g) are then sprinkled on the active material and the mold is removed. Finally, a compressive stress of 800 MPa is applied for 5 minutes and then released. The as-obtained pills, have diameter of 2 cm, thickness of 0.05 cm and weight of 0.35 g.

Without being bound to any theory the inventors deem that fluxing different selected gaseous species during the preparation procedure could enhance the final performances of the as obtained EPG, in terms of OCV, according to the series N₂ > Air (wet) > Air (dry) > O₂ (dry) > CO₂ (dry).)

### Example 2:

### Preparation of an EPG of the invention

In a typical procedure, aluminum foil of thickness of about 100 µm is placed at the bottom of a circle-shaped mold of 1.5 cm diameter. 0.1 g of ZrO₂ powder with average diameter in the range from 10 nm to 40 µm, preferably in the range of 1-10 µm, more preferably 2-5 µm as sold by Sigma-Aldrich is sprinkled on Al and gently pressed with a piston at 0.01 MPa to compact the active powder. Copper foil (50 µm of thickness and 1.5 cm of diameter) or copper powder (20 µm mesh, 0.03 g) are then sprinkled on the active material and the mold is removed. Finally, a compressive stress of 800 MPa is applied for 5 minutes and then released. The as-obtained pills have diameter of 1.5 cm and an active area of 1.76 cm².

Without being bound to any theory the inventors deem that fluxing different selected gaseous species during the preparation procedure could enhance the final performances of the as obtained EPG, in terms of OCV, according to the series N₂ > Air (wet) > Air (dry) > O₂ (dry) > CO₂ (dry).

### Example 3:

### Preparation of an EPG of the invention

In a typical procedure, aluminum foil of thickness of about 100 µm is placed at the bottom of a circle-shaped mold of 1.5 cm diameter. 0.1 g of MgO powder with average diameter in the range from 10 nm to 40 µm, preferably in the range of 1-10 µm, more preferably 2-5 µm as sold by Sigma-Aldrich is sprinkled on Al and gently pressed with a piston at 0.01 MPa to compact the active powder. Copper foil (50 µm of thickness and 1.5 cm of diameter) or copper powder (20 µm mesh, 0.03 g) are then sprinkled on the active material and the mold is removed. Finally, a compressive stress of 800 MPa is applied for 5 minutes and then released. The as-obtained pills, have diameter of 1.5 cm and an active area of 1.76 cm².

Without being bound to any theory the inventors deem that fluxing different selected gaseous species during the preparation procedure could enhance the final performances of the as obtained EPG, in terms of OCV, according to the series N₂ > Air (wet) > Air (dry) > O₂ (dry) > CO₂ (dry).

### Example 4:

### Preparation of an EPG of the invention

In a typical procedure, aluminum foil of thickness of about 100 µm is placed at the bottom of a circle-shaped mold of 1.5 cm diameter. 0.1 g of In₂O₃ powder with average diameter in the range from 10 nm to 40 µm, preferably in the range of 1-10 µm, more preferably 2-5 µm as sold by Sigma-Aldrich is sprinkled on Al and gently pressed with a piston at 0.01 MPa to compact the active powder. Copper foil (50 µm of thickness and 1.5 cm of diameter) or copper powder (20 µm mesh, 0.03 g) are then sprinkled on the active material and the mold is removed. Finally, a compressive stress of 800 MPa is applied for 5 minutes and then released. The as-obtained pills, have diameter of 1.5 cm and an active area of 1.76 cm².

Without being bound to any theory the inventors deem that fluxing different selected gaseous species during the preparation procedure could enhance the final performances of the as obtained EPG, in terms of OCV, according to the series N₂ > Air (wet) > Air (dry) > O₂ (dry) > CO₂ (dry).

### Example 5:

### Preparation of an EPG of the invention

In a typical procedure, aluminum foil of thickness of about 100 µm is placed at the bottom of a circle-shaped mold of 1.5 cm diameter. 0.1 g of GeO2 powder with average diameter in the range from 10 nm to 40 µm, preferably in the range of 1-10 µm, more preferably 2-5 µm as sold by Sigma-Aldrich is sprinkled on Al and gently pressed with a piston at 0.01 MPa to compact the active powder. Copper foil (50 µm of thickness and 1.5 cm of diameter) or copper powder (20 µm mesh, 0.03 g) are then sprinkled on the active material and the mold is removed. Finally, a compressive stress of 800 MPa is applied for 5 minutes and then released. The as-obtained pills, have diameter of 1.5 cm and an active area of 1.76 cm².

Without being bound to any theory the inventors deem that fluxing different selected gaseous species during the preparation procedure could enhance the final performances of the as obtained EPG, in terms of OCV, according to the series N₂ > Air (wet) > Air (dry) > O₂ (dry) > CO₂ (dry).

### Example 6:

### Preparation of an active material for an EPG of the invention

In a typical procedure, PVDF (polyvinylidene fluoride) flakes (or powder) were mixed to NMP (N-methyl-2-pyrrolidone) solvent and stirred for a range time comprised in the range from 12 h to 48 h, until a complete solute dissolution was reached. In a preferred embodiment, to fasten PVDF dissolution temperature could be raised up to maximum of 80 °C.

PVDF content in the solution was at least 0.5%, preferably in the range from 4% to 10 % with respect to the total weight.

After this step, oxide powders with average diameter in the range from 10 nm to 40 µm, preferably in the range of 1-10 µm, more preferably 2-5 µm as sold by Sigma-Aldrich were added in amount of at least 0.6%, preferably from 10% to 30% with respect to the total weight of the active material. The as obtained mixture had a viscosity value preferably comprised in the range from 1000 cPa to 10000 cPa, more preferably from 5000 cPa to 7000 cPa, as measured with the rotatory viscometer Viscotester VTR5 at rpm =20 at T=25°C.

The composition is reported in the following table.

| Chemical | Amount [g] |
|---|---|
| NMP | 72 |
| PVDF | 8 |
| MgO | 15 |
| ZrO₂ | 5 |

Without being bound to any theory the inventors deem that fluxing different selected gaseous species during the preparation procedure could enhance the final performances of the as obtained EPG, in terms of OCV, according to the series N₂ > Air (wet) > Air (dry) > O₂ (dry) > CO₂ (dry).

### Example 7:

### Preparation of an EPG of the invention

An electric power generator EPG was assembled by using the composition of the active material of Example 6.

Two squared electrodes, respectively made of Cu and Al and having the same area (about 25 cm²) were cleaned and etched in order to be used for assembling the electric power generator. The active material containing oxides powders with average diameter in the range from 10 nm to 40 µm, preferably in the range of 1-10 µm, more preferably 2-5 µm as sold by Sigma-Aldrich was then deposited on the surface of Cu electrode with doctor blade technique. The thickness of the active material was about 500µm. The product so obtained was baked at a range of temperature from 60°C to 100 °C, preferably from 70 °C to 90°C for a period of time in the range of 30 minutes to 12 hours, preferably 2 hours in order to dry the active material, thus obtaining a solid electric power generator. After this step, the electrode of Al was placed on top of the deposited active material in a parallel way with respect to the Cu electrode. The two electrodes were gently pressed together assuring a uniform contact of the active material with their own surface.

The used oxygen-containing compound and hence the active material contained coordinated water in the range from 0.5% by weight to 7.5% by weight with respect to oxygen-containing compound, preferably from 0.5% to 3.5%, more preferably from 0.5% to 1.5%.

### Example 8:

### Preparation of an EPG of the invention

An electric power generator EPG was assembled by using the composition of the active material of example 6.

Two squared electrodes, respectively made of Cu and Al and having the same area (about 25 cm²) were cleaned and etched in order to be used for assembling the electric power generator. The active material containing oxides powders with average diameter in the range from 10 nm to 40 µm, preferably in the range of 1-10 µm, more preferably 2-5 µm as sold by Sigma-Aldrich was then deposited on the surface of Cu electrode with spin coating technique accelerating the substrate from 0 to 1000 rpm for 30 seconds and further 60 seconds at 1000 rpm.

The product so obtained was baked at a range of temperature from 60°C to 120 °C, preferably from 80°C to 100 °C for a period of time in the range of 30 minutes to 12 hours, preferably 2 hours in order to dry the active material, thus obtaining a solid electric power generator. After this step, the electrode of Al was placed on top of the deposited active material in a parallel way with respect to the Cu electrode. The two electrodes were gently pressed together assuring a uniform contact of the active material with their own surface.

The used oxygen-containing compound and hence the active material contained coordinated water in the range from 0.5% by weight to 7.5% by weight with respect to oxygen-containing compound preferably from 0.5% to 3.5%, more preferably from 0.5% to 1.5%.

### Example 9:

### Preparation of an active material of an EPG of the invention

In a typical procedure, Mg-methoxide (6-10 wt% solution in methanol) is employed as a precursor. Dry methanol, acetic acid and monoethanolamine are used respectively as a solvent and stabilizers. Mg-methoxide (2-10 mL) was diluted in dry methanol (4-12mL) while acetic acid (0.02-0.1 mL, ratio AA/alkoxide 0.1-0.5) and monoethanolamine (0.01-0.05 mL) were added to dry methanol (4-12 mL) in another flask. Then, the acetic acid and monoethanolamine solution was added to the Mg precursor solution, followed by reaction for 0.5-4 h. The MgO solution was then sonicated at 50°C for 5-30 minutes and followed by heating, stirring and ageing for 12-24 h. The as obtained gel can be applied on the metal electrode by simple dip coating or spin coating techniques and thermally treated at 180-700°C, preferably 200-500°C, more preferably 250-450°C. Thermal treatment duration ranges 5-100 minutes, preferably 5-30 minutes, more preferably 5-20 minutes. The counter electrode can be applied on the gel-coated electrode before the thermal treatment or after the thermal treatment itself.

Without being bound to any theory the inventors deem that fluxing different selected gaseous species during the preparation procedure could enhance the final performances of the as obtained EPG, in terms of OCV, according to the series N₂ > Air (wet) > Air (dry) > O₂ (dry) > CO₂ (dry).

### Example 10:

### Electrical characterization of an EPG of the invention

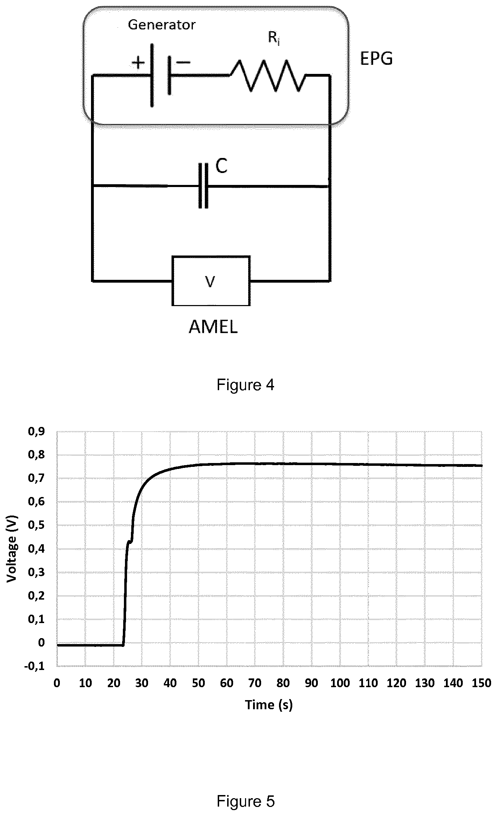

The EPG of Example 2 was electrically characterized by using AMEL2553 potentiostat/galvanostat. The electrical circuit is shown in Figure 4. More in detail, Figure 4 shows the EPG, providing a current in, coupled with its own internal resistance (Ri). The latter is normally defined as a ratio between the open circuit potential and the short circuit current. The EPG was connected in series to a capacitor of 10 µF and the voltage of the capacitor was monitored by connecting the galvanostat parallel to it. The source resistance (Ri) is strongly dependent on the components of the active material. The active material resulted to have a low conductivity. The electric power generator was characterized by running a potentiometric analysis setting a null current (open voltage). The result is shown in Figure 5. Referring to the latter, it can be seen that after 35 s the capacitor was charged up to 760 mV, corresponding to 8×10⁻¹⁰ Wh.

### Example 11:

### Thermal characterization of an EPG of the invention.

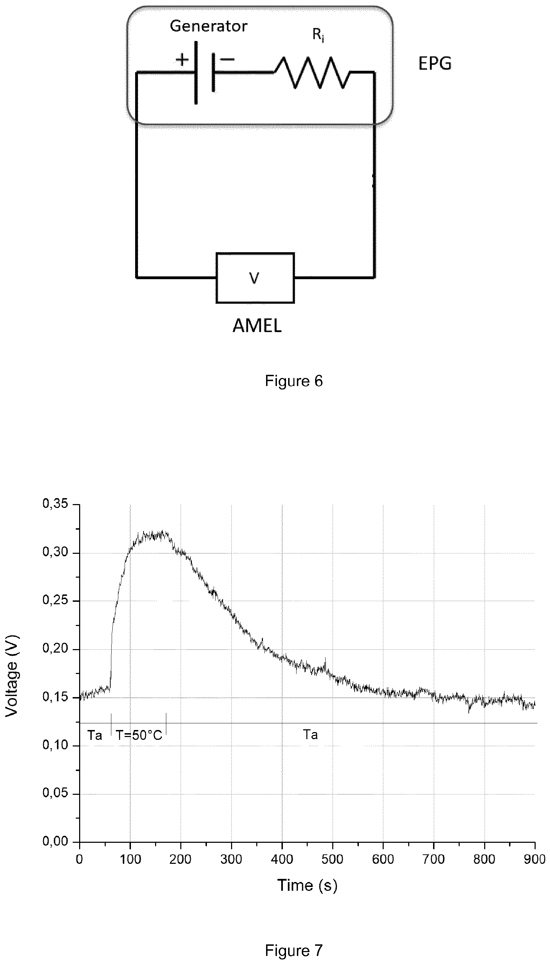

The electric power generator of Example 3 was tested at different temperatures using the circuit scheme reported in Figure 6. The test lasted 900 seconds. During its first 60 seconds, an open voltage measurement at ambient temperature (i.e. 18 °C) has been performed. Then, the EPG was heated at temperature equal to 50°C. This temperature was kept constant for 100 seconds. After this time interval, the EPG was cooled down in ambient temperature (Tₐ). The OCV was monitored for all the experiment duration. The experiment has been performed using AMEL2553 potentiostat/galvanostat.

The curve reported in Figure 7 was obtained. The measured open voltage at temperature equal to 50°C is 1.5 times higher with respect to the initial value. After the time interval at 50 °C, the OCV decreased gradually with the decrease of temperature.

### Example 12:

### Electrical characterization of an EPG of the invention

The possibility of working with alternate discharge has been evaluated for an EPG having the features as in the Example 1, namely thickness, active medium, composition, electrodes material, electrodes area as in the Example 1. For this test, an electrical circuit as in Figures 2A and 2B has been used. In said circuit, a load resistance R_{L} of 10 Ohm has been provided. The alternate discharge comprises 5 minutes of working and 5 minutes of rest. However, different ON-OFF times can be applied. In the 5 minutes of working the circuit is closed and capacitor is charged by the EPG. In the 5 minutes of rest, the circuit is open and the capacitor is discharged by load resistance R_{L}. The expression "ON STATE" wants to indicate a working period in which capacitor is charged. In the specific case, this condition occurred cyclically every 5 minutes. For the following 5 minutes, the capacitor was disconnected (OFF STATE) from the EPG and discharged by the R_{L}.

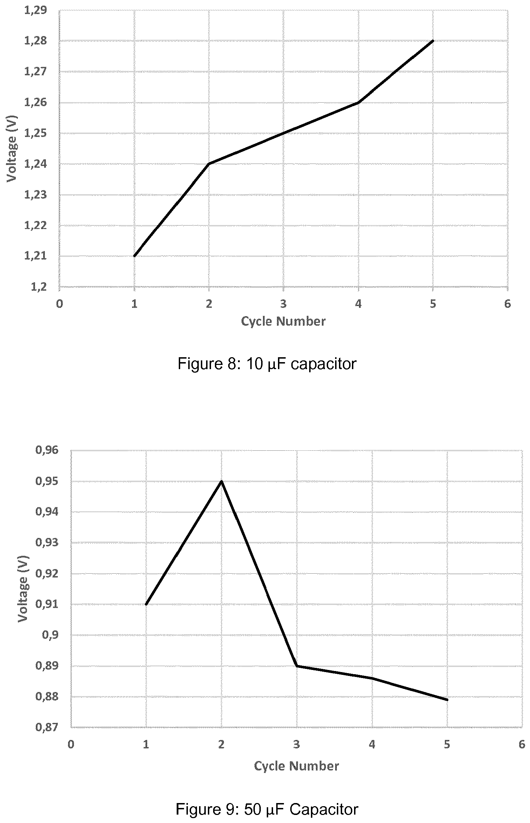

This kind of experiment was performed on both 10 µF and 50 µF capacitors. Figure 8 and Figure 9 show the OCV values for the capacitor immediately at the beginning of the OFF state for the 10 µF and 50 µF capacitor respectively.

**Table 1**

| Capacitor | Average OCV [V] | Wh | Wh/L | Wh/Kg |
|---|---|---|---|---|
| 10 µF | 1.25 | 2.16E-09 | 1.38E-05 | 6.07E-06 |
| 50 µF | 0.9 | 5.66E-09 | 3.61 E-05 | 1.59E-05 |

Considering values listed in Table 1, it can be noticed that increasing the capacity of the capacitor five times, the relative supplied energy is almost 2.6 times higher. It is clear that the circuit has a strong influence on the EPG performances.

### Example 13:

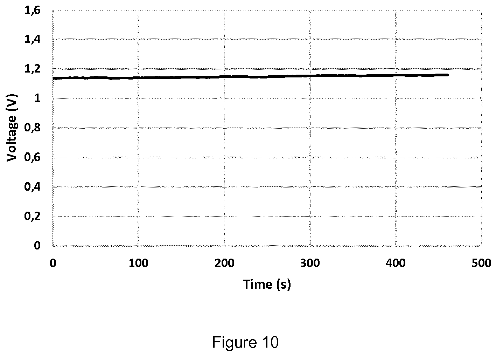

The electric power generator of Example 2 was tested by using AMEL2553 potentiostat/galvanostat in the open circuit voltage (OCV) detection. The circuit scheme is reported in Figure 6. The OCV measure over time is shown in the Figure 10 in which it is possible to see that the OCV value is stable in time at 1.135 V.

### Example 14:

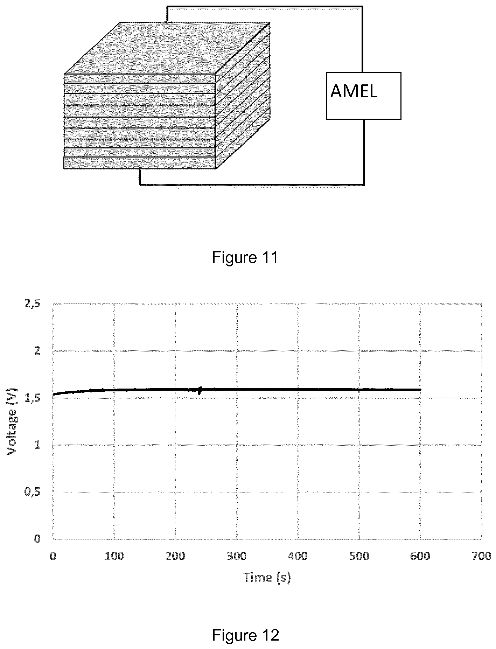

In order to demonstrate the possibility to have a Power Generator Module (PGM) able to supply higher power values, three EPGs fabricated according to Example 1 were connected in series. The open circuit voltage was monitored with AMEL2553 potentiostat/galvanostat. The electrical circuit is reported in Figure 11. Figure 12 shows that the OCV value at room temperature for three EPGs is constant in time at 1.6 V while the OCV value for the single EPG based on the Example 1 is around 0.5 V.

## Claims

1. An electric power generator (EPG) comprising at least a first electrode (11) and a second electrode (12), wherein the electric power generator comprises an active material between said electrodes (11,12), said active material comprising at least one oxygen-containing compound selected from the group consisting of MgO, ZnO, ZrOCl₂, ZrO₂, SiO₂, Bi₂O₃, Fe₃O₄, Al₂O₃,TiO₂, BeO, CaO, Ga₂O₃, In203, GeO₂, SnO₂ and PbO₂, wherein the particle size of the oxygen-containing compound has an average diameter in the range from 10 nm to 40 µm and wherein a thickener additive selected from the group consisting of agar agar, xanthan gum, methyl cellulose, and arabic gum is absent and wherein the at least one oxygen-containing compound or a mixture thereof is in an amount in the range from 50% to 100% (w/w) with respect to the amount of the active material.

2. The electric power generator (EPG) of claim 1, wherein a cellulose compound as a thickener agent is absent.

3. The electric power generator (EPG) of claim 1 or claim 2, wherein the at least one oxygen-containing compound selected from the group consisting of MgO, ZnO, ZrOCl₂, ZrO₂, SiO₂, Bi₂O₃, Fe₃O₄, Al₂O₃,TiO₂, BeO, CaO, Ga₂O₃, In203, GeO₂, SnO₂ and PbO₂ or a mixture thereof is in an amount in the range 50-80% (w/w) with respect to the amount of the active material.

4. The electric power generator (EPG) of anyone of claims 1-3, wherein the at least one oxygen-containing compound of the active material has particle average diameter in the range from 5 nm to 40 µm, preferably in the range of 15 nm-10 µm, more preferably 20 nm-5 µm.

5. The electric power generator (EPG) of anyone of claims 1-3, wherein the at least one oxygen-containing compound of the active material has particle average diameter in the range from 10 to 200 nm, preferably in the range of 15-100 nm, more preferably 20-40 nm.

6. The electric power generator (EPG) of anyone of claims 1-5, wherein the at least one oxygen-containing compound of the active material is MgO, in the range from 50% and 100% (w/w), preferably in the range of 50% and 80% (w/w) with respect to the amount of the active material.

7. The electric power generator (EPG) of anyone of claims 1-5, wherein the at least one oxygen-containing compound of the active material is ZnO or ZrO₂.

8. The electric power generator (EPG) according to anyone of claims 1-5, wherein the active material comprises MgO, ZnO, ZrO₂.

9. The electric power generator (EPG) according to anyone of claims 1-8, wherein the active material comprises also at least one plasticizer additive.

10. The electric power generator according to claim 9, wherein the at least one plasticizer additive is selected from the group consisting of siloxanes, Carnauba Wax, Naphtalene, PVDF, Parylene, PTFE, FEP, PDMS, aqueous based polymers and bio-polymers.

11. The electric power generator according to anyone of claims 1-10, wherein the oxygen-containing compound contains coordinated water in the range from 0.5% by weight to 7.5% by weight with respect to oxygen-containing compound, preferably from 0.5% to 3.5%, more preferably from 0.5% to 1.5%.

12. The electric power generator (EPG) according to anyone of claims 1-11, wherein said electrodes are made of the different materials in form of powders or metal foils.

13. The electric power generator (EPG) according to anyone of claims 1-11, wherein said electrodes are made of the same material.

14. The electric power generator (EPG) according to Claim 12, wherein said first electrode (11) is made of copper and wherein said second electrode is made of aluminum.

15. The electric power generator (EPG) according to Claim 13, wherein said electrodes are made of copper.

16. The electric power generator (EPG) according to Claim 13, wherein said electrodes are made of aluminum.

17. The electric power generator (EPG) according to Claim 13, wherein said electrodes are made of graphite.

18. The electric power generator (EPG) according to Claim 12, wherein said electrodes are made of a material selected in a group consisting of metals, alloys and carbon-based materials.

19. A power generator module (PGM) **characterized in that** it comprises a plurality of electric power generators (EPGs) according to any one of the claims 1-18, wherein said generators are connected in parallel or in series.

20. An electric circuit (EC) comprising an EPG according to any one of the Claims 1 to 18, wherein said circuit (EC) also comprises, a capacitor (C), a resistor (R_{L}) and a switch (SW) and wherein:
- in a first switching state, said switch (SW) connects said capacitor (C) in series with said EPG; and
- in a second switching state, said switch (SW) connects said capacitor (C) in series with said resistor (R_{L}).

21. An electric circuit (EC) comprising an PGM according to Claim 19, wherein said circuit (EC) also comprises, a capacitor (C), a resistor (R_{L}) and a switch (SW) and wherein:
- in a first switching state, said switch (SW) connects said capacitor (C) in series with said PGM; and
- in a second switching state, said switch (SW) connects said capacitor (C) in series with said resistor (R_{L}).

## Patentansprüche

1. Elektrischer Stromgenerator (EPG) umfassend mindestens eine erste Elektrode (11) und eine zweite Elektrode (12), wobei der elektrische Stromgenerator ein aktives Material zwischen den Elektroden (11,12) umfasst, wobei das aktive Material mindestens eine sauerstoffhaltige Verbindung umfasst, die aus der Gruppe bestehend aus MgO, ZnO, ZrOCl₂, ZrO₂, SiO₂, Bi₂O₃, Fe₃O₄, Al₂O₃, TiO₂, BeO, CaO, Ga₂O₃, In₂O₃, GeO₂, SnO₂ und PbO₂, ausgewählt ist, wobei die Teilchengröße der sauerstoffhaltigen Verbindung einen durchschnittlichen Durchmesser im Bereich von 10 nm bis 40 µm aufweist und wobei kein Verdickungsadditiv, ausgewählt aus der Gruppe, bestehend aus Agar-Agar, Xanthan, Methylzellulose und Gummi arabicum, vorhanden ist und wobei die mindestens eine sauerstoffhaltige Verbindung oder eine Mischung davon in einer Menge im Bereich von 50 % bis 100 % (Gewichtsprozent) in Bezug auf die Menge des aktiven Materials vorliegt.

2. Elektrischer Stromgenerator (EPG) nach Anspruch 1, wobei eine Zelluloseverbindung als Verdickungsmittel fehlt.

3. Elektrischer Stromgenerator (EPG) nach Anspruch 1 oder Anspruch 2, wobei die mindestens eine sauerstoffhaltige Verbindung, die aus der Gruppe ausgewählt ist, die aus MgO, ZnO, ZrOCl₂, ZrO₂, SiO₂, Bi₂O₃, Fe₃O₄, Al₂O₃, TiO₂, BeO, CaO, Ga₂O₃, In₂O₃, GeO₂, SnO₂ und PbO₂ oder einem Gemisch davon besteht, in einer Menge im Bereich von 50 bis 80 % (Gewichtsprozent) in Bezug auf die Menge des aktiven Materials vorliegt.

4. Elektrischer Stromgenerator (EPG) nach einem der Ansprüche 1 bis 3, wobei die mindestens eine sauerstoffhaltige Verbindung des aktiven Materials einen durchschnittlichen Teilchendurchmesser im Bereich von 5 nm bis 40 µm, vorzugsweise im Bereich von 15 nm-10 µm, besonders bevorzugt 20 nm-5 µm, aufweist.

5. Elektrischer Stromgenerator (EPG) nach einem der Ansprüche 1 bis 3, wobei die mindestens eine sauerstoffhaltige Verbindung des aktiven Materials einen durchschnittlichen Teilchendurchmesser im Bereich von 10 bis 200 nm, vorzugsweise im Bereich von 15 bis 100 nm, besonders bevorzugt 20 bis 40 nm, aufweist.

6. Elektrischer Stromgenerator (EPG) nach einem der Ansprüche 1-5, wobei die mindestens eine sauerstoffhaltige Verbindung des aktiven Materials MgO ist, im Bereich von 50 % und 100 % (Gewichtsprozent), vorzugsweise im Bereich von 50 % und 80 % (Gewichtsprozent) in Bezug auf die Menge des aktiven Materials.

7. Elektrischer Stromgenerator (EPG) nach einem der Ansprüche 1-5, wobei die mindestens eine sauerstoffhaltige Verbindung des aktiven Materials ZnO oder ZrO₂ ist.

8. Elektrischer Stromgenerator (EPG) nach einem der Ansprüche 1-5, wobei das aktive Material MgO, ZnO, ZrO₂ umfasst.

9. Elektrischer Stromgenerator (EPG) nach einem der Ansprüche 1-8, wobei das aktive Material auch mindestens einen Weichmacherzusatz enthält.

10. Elektrischer Stromgenerator nach Anspruch 9, wobei der mindestens eine Weichmacherzusatz aus der Gruppe ausgewählt ist, die aus Siloxanen, Carnaubawachs, Naphtalene, PVDF, Parylene, PTFE, FEP, PDMS, Polymeren auf Wasserbasis und Biopolymeren besteht.

11. Elektrischer Stromgenerator nach einem der Ansprüche 1 bis 10, wobei die sauerstoffhaltige Verbindung koordiniertes Wasser im Bereich von 0,5 Gew.-% bis 7,5 Gew.-%, bezogen auf die sauerstoffhaltige Verbindung, enthält, vorzugsweise von 0,5 % bis 3,5 %, besonders bevorzugt von 0,5 % bis 1,5 %.

12. Elektrischer Stromgenerator (EPG) nach einem der Ansprüche 1 bis 11, wobei die Elektroden aus den verschiedenen Materialien in Form von Pulvern oder Metallfolien hergestellt sind.

13. Elektrischer Stromgenerator (EPG) nach einem der Ansprüche 1 bis 11, wobei die Elektroden aus dem gleichen Material hergestellt sind.

14. Elektrischer Stromgenerator (EPG) nach Anspruch 12, wobei die erste Elektrode (11) aus Kupfer und die zweite Elektrode aus Aluminium hergestellt ist.

15. Elektrischer Stromgenerator (EPG) nach Anspruch 13, wobei die Elektroden aus Kupfer hergestellt sind.

16. Elektrischer Stromgenerator (EPG) nach Anspruch 13, wobei die Elektroden aus Aluminium hergestellt sind.

17. Elektrischer Stromgenerator (EPG) nach Anspruch 13, wobei die Elektroden aus Graphit hergestellt sind.

18. Elektrischer Stromgenerator (EPG) nach Anspruch 12, wobei die Elektroden aus einem Material bestehen, das aus einer Gruppe ausgewählt ist, die aus Metallen, Legierungen und Materialien auf Kohlenstoffbasis besteht.

19. Stromgeneratormodul (PGM), **dadurch gekennzeichnet, dass** es eine Vielzahl von elektrischen Stromgeneratoren (EPG) nach einem der Ansprüche 1-18 umfasst, wobei die Generatoren parallel oder in Reihe geschaltet sind.

20. Elektrische Schaltung (EC) mit einem EPG nach einem der Ansprüche 1 bis 18, wobei die Schaltung (EC) auch einen Kondensator (C), einen Widerstand (RL) und einen Schalter (SW) aufweist und wobei:
- der Schalter (SW) in einem ersten Schaltzustand den Kondensator (C) in Reihe mit dem EPG schaltet; und
- in einem zweiten Schaltzustand der Schalter (SW) den Kondensator (C) in Reihe mit dem Widerstand (RL) schaltet.

21. Elektrische Schaltung (EC) die ein PGM nach Anspruch 19 umfasst, wobei die Schaltung (EC) auch einen Kondensator (C), einen Widerstand (RL) und einen Schalter (SW) umfasst und wobei:
- der Schalter (SW) in einem ersten Schaltzustand den Kondensator (C) in Reihe mit dem PGM schaltet; und
- in einem zweiten Schaltzustand der Schalter (SW) den Kondensator (C) in Reihe mit dem Widerstand (RL) schaltet.

## Revendications

1. Générateur de puissance électrique (EPG) comprenant au moins une première électrode (11) et une seconde électrode (12), dans lequel le générateur de puissance électrique comprend un matériau actif entre lesdites électrodes (11,12), ledit matériau actif comprenant au moins un composé contenant de l'oxygène sélectionné parmi le groupe constitué de MgO, ZnO, ZrOCl₂, ZrO₂, SiO₂, Bi₂O₃, Fe₃O₄, Al₂O₃, TiO₂, BeO, CaO, Ga₂O₃, In₂O₃, GeO₂, SnO₂ et PbO₂, dans lequel la dimension des particules du composé contenant de l'oxygène a un diamètre moyen dans la gamme de 10 nm à 40 µm et dans lequel un additif épaississant sélectionné parmi le groupe constitué d'agar-agar, gomme xanthane, méthylcellulose et gomme arabique est absent et dans lequel l'au moins un composé contenant de l'oxygène ou un mélange de ceux-ci est en une quantité dans la gamme de 50 % à 100 % (p/p) par rapport à la quantité du matériau actif.

2. Générateur de puissance électrique (EPG) de la revendication 1, dans lequel un composé de cellulose en tant qu'agent épaississant est absent.

3. Générateur de puissance électrique (EPG) selon la revendication 1 ou la revendication 2, dans lequel l'au moins un composé contenant de l'oxygène sélectionné parmi le groupe constitué de MgO, ZnO, ZrOCl₂, ZrO₂, SiO₂, Bi₂O₃, Fe₃O₄, Al₂O₃, TiO₂, BeO, CaO, Ga₂O₃, In₂O₃, GeO₂, SnO₂ et PbO₂ ou un mélange de ceux-ci est en une quantité dans la gamme 50-80 % (p/p) par rapport à la quantité du matériau actif.

4. Générateur de puissance électrique (EPG) de l'une quelconque des revendications 1-3, dans lequel l'au moins un composé contenant de l'oxygène du matériau actif a un diamètre moyen des particules dans la gamme de 5 nm à 40 µm, de préférence dans la gamme de 15 nm-10 µm, plus préférablement 20 nm-5 µm.

5. Générateur de puissance électrique (EPG) de l'une quelconque des revendications 1-3, dans lequel l'au moins un composé contenant de l'oxygène du matériau actif a un diamètre moyen des particules dans la gamme de 10 à 200 nm, de préférence dans la gamme de 15-100 nm, plus préférablement 20-40 nm.

6. Générateur de puissance électrique (EPG) de l'une quelconque des revendications 1-5, dans lequel l'au moins un composé contenant de l'oxygène du matériau actif est MgO, dans la gamme de 50 % à 100 % (p/p), de préférence dans la gamme de 50 % et 80 % (p/p) par rapport à la quantité du matériau actif.

7. Générateur de puissance électrique (EPG) de l'une quelconque des revendications 1-5, dans lequel l'au moins un composé contenant de l'oxygène du matériau actif est ZnO ou ZrO₂.

8. Générateur de puissance électrique (EPG) selon l'une quelconque des revendications 1-5, dans lequel le matériau actif comprend MgO, ZnO, ZrO₂.

9. Générateur de puissance électrique (GPE) selon l'une quelconque des revendications 1-8, dans lequel le matériau actif comprend également au moins un additif plastifiant.

10. Générateur de puissance électrique selon la revendication 9, dans lequel l'au moins un additif plastifiant est sélectionné parmi le groupe constitué de siloxanes, cire de carnauba, naphtalène, PVDF, parylène, PTFE, FEP, PDMS, polymères à base aqueuse et biopolymères.

11. Générateur de puissance électrique selon l'une quelconque des revendications 1-10, dans lequel le composé contenant de l'oxygène contient de l'eau coordonnée dans la gamme de 0,5 % en poids à 7,5 % en poids par rapport au composé contenant de l'oxygène, de préférence de 0,5 % à 3,5 %, plus préférablement de 0,5 % à 1,5 %.

12. Générateur de puissance électrique (EPG) selon l'une quelconque des revendications 1-11, dans lequel lesdites électrodes sont faites des différents matériaux sous forme de poudres ou de feuilles métalliques.

13. Générateur de puissance électrique (EPG) selon l'une quelconque des revendications 1-11, dans lequel lesdites électrodes sont faites du même matériau.

14. Générateur de puissance électrique (EPG) selon la revendication 12, dans lequel ladite première électrode (11) est faite de cuivre et dans lequel ladite seconde électrode est faite d'aluminium.

15. Générateur de puissance électrique (EPG) selon la revendication 13, dans lequel lesdites électrodes sont faites de cuivre.

16. Générateur de puissance électrique (EPG) selon la revendication 13, dans lequel lesdites électrodes sont faites d'aluminium.

17. Générateur de puissance électrique (EPG) selon la revendication 13, dans lequel lesdites électrodes sont faites de graphite.

18. Générateur de puissance électrique (EPG) selon la revendication 12, dans lequel lesdites électrodes sont faites d'un matériau sélectionné parmi un groupe constitué de métaux, alliages et matériaux à base de carbone.

19. Module générateur de puissance (MGP) **caractérisé en ce qu'**il comprend une pluralité de générateurs de puissance électrique (EPG) selon l'une quelconque des revendications 1-18, dans lequel lesdits générateurs sont connectés en parallèle ou en série.

20. Circuit électrique (EC) comprenant un EPG selon l'une quelconque des revendications 1 à 18, dans lequel ledit circuit (EC) comprend également un condensateur (C), une résistance (RL) et un commutateur (SW) et dans lequel :
- dans un premier état de commutation, ledit commutateur (SW) connecte ledit condensateur (C) en série avec ledit EPG ; et
- dans un second état de commutation, ledit commutateur (SW) connecte ledit condensateur (C) en série avec ladite résistance (RL).

21. Circuit électrique (EC) comprenant un PGM selon la revendication 19, dans lequel ledit circuit (EC) comprend en outre un condensateur (C), une résistance (RL) et un commutateur (SW) et dans lequel :
- dans un premier état de commutation, ledit commutateur (SW) connecte ledit condensateur (C) en série avec ledit PGM ; et
- dans un second état de commutation, ledit commutateur (SW) connecte ledit condensateur (C) en série avec ladite résistance (RL).
